(19) Europäisches Patentamt
European Patent Office
Office européen des brevets

(11) **EP 2 346 176 A1**

(12) **EUROPEAN PATENT APPLICATION**
published in accordance with Art. 153(4) EPC

(43) Date of publication:
**20.07.2011 Bulletin 2011/29**

(51) Int Cl.:
*H04B 1/26* (2006.01)   *H04B 1/16* (2006.01)
*H04B 1/707* (2011.01)

(21) Application number: **09825909.6**

(22) Date of filing: **11.11.2009**

(86) International application number:
**PCT/JP2009/006028**

(87) International publication number:
**WO 2010/055655 (20.05.2010 Gazette 2010/20)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**
Designated Extension States:
**AL BA RS**

(30) Priority: **11.11.2008 JP 2008289062**

(71) Applicant: **NEC Corporation
Minato-ku
Tokyo 108-8001 (JP)**

(72) Inventor: **OGA, Toshiyuki
Tokyo 108-8001 (JP)**

(74) Representative: **Glawe, Delfs, Moll
Patent- und Rechtsanwälte
Postfach 26 01 62
80058 München (DE)**

(54) **MOBILE WIRELESS COMMUNICATION SYSTEM, MOBILE COMMUNICATION DEVICE, AND FREQUENCY CONTROL METHOD**

(57)     A mobile communication device and a frequency control method for the device are provided that can have an internal reference frequency follow a change in reception frequency even when the reception frequency changes abruptly. In a mobile radio communication system including a mobile station (54) and a stationary base station (55), the mobile station includes: a transceiver that receives a high-frequency signal from the base station; and an information processing section (53) that predicts a frequency change in the reception high-frequency signal received from the base station based on mobile environment information on the mobile station provided from outside and controls a frequency of a local oscillator signal of the transceiver section based on a prediction result.

**FIG.2**

54; MOBILE STATION (MOBILE COMMUNICATION DEVICE)

MOBILE ENVIRONMENT INFORMATION

(x, d, u)

BASE STATION — 55

51

52 TRANSCEIVER SECTION (TRX)

RECEPTION DATA RDA
TRANSMISSION DATA TDA
FREQUENCY CONTROL DATA FCD

53 INFORMATION PROCESSING SECTION

EP 2 346 176 A1

**Description**

[Technical Field]

The present invention relates to a mobile radio communication system and, more particularly, to a mobile communication device moving at high speed relatively to a fixedly installed base station, as well as a frequency control method for the device.

[Background Art]

In mobile communications systems typified by CDMA (Code Division Multiple Access) cellular telephone systems, constant considerations are required to changes in radio environment caused by the movements of mobile stations. The occurrence of a frequency error, which is caused by the interference of reflected waves and the Doppler effect dependent on the moving velocity of a mobile station, is unavoidable. Data cannot be correctly demodulated if a received frequency at a mobile station deviates, due to movement, from a frequency that would be received when the mobile station was stationary, that is, a transmission frequency at a base station. Therefore, mobile stations are provided with feedback mechanisms to estimate a reference frequency on the base station side and correct a frequency error.
As an example, a brief description will be given of an automatic frequency control system in a CDMA mobile telephone device disclosed in PTL 1.

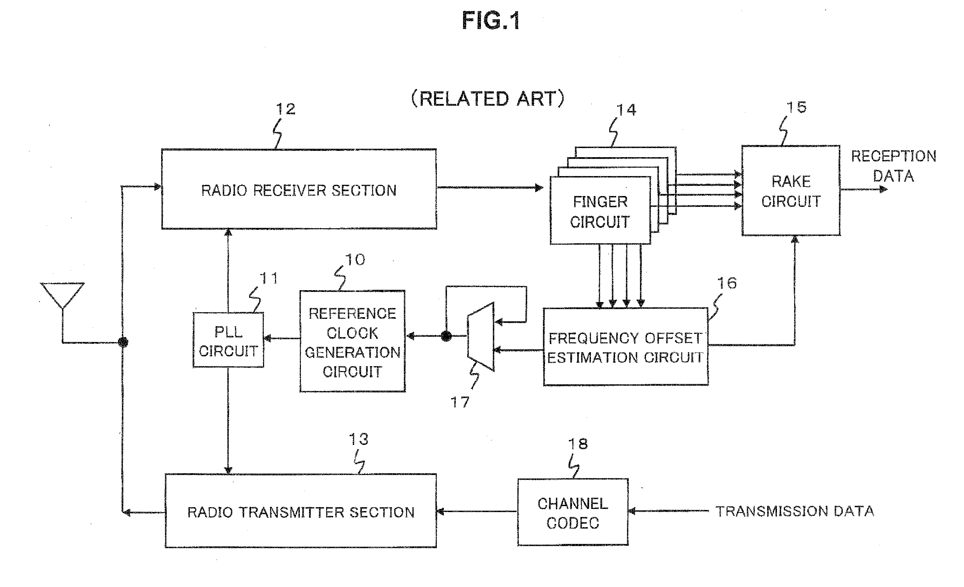

FIG. 1 is a schematic block diagram showing an example of a transceiver section in a general CDMA mobile telephone device. The mobile telephone device is provided with a voltage-controlled reference clock generation circuit 10 that generates a reference clock serving as a reference for the operation timing of the entire device. Using the reference clock generated by the reference clock generation circuit 10 as a reference frequency, a PLL (Phase-Locked Loop) circuit 11 generates a reception local oscillator signal and a transmission local oscillator signal and outputs them to a radio receiver section 12 and a radio transmitter section 13, respectively.
The radio receiver section 12 performs down-conversion and quasi-synchronous demodulation on a reception high-frequency signal by using the reception local oscillator signal and outputs it as a reception digital baseband signal to a finger circuit 14. The finger circuit 14 outputs, for each finger, a demodulated signal of the reception digital baseband signal to a RAKE circuit 15 and pilot data to a frequency offset estimation circuit 16, and the RAKE circuit 15 generates reception data by using frequency offset amounts from the frequency offset estimation circuit 16.
The frequency offset estimation circuit 16 calculates, based on the pilot data from each finger, the reception-frequency offsets to output to the RAKE circuit 15 and also outputs a frequency offset synthesized from these offsets to an accumulator circuit 17. The accumulator circuit 17 outputs the value of an accumulation of such synthesized frequency offsets as control voltage data to the reference clock generation circuit 10. In this manner, the reference clock frequency output from the reference clock generation circuit 10 is automatically controlled through frequency offset estimation, whereby variations in reception frequency can be corrected. In accordance with the thus corrected frequency clock, the local oscillator signal for down-conversion and for quadrature demodulation is generated and output to the radio receiver section 12. Similarly, in accordance with the corrected frequency clock, the local oscillator signal for up-conversion and for quadrature modulation is generated and output to the radio transmitter section 13. Incidentally, transmission data is encoded through a predetermined scheme by a channel codec 18 and output to the radio transmitter section 13.
Note that the reason for the reference clock of the mobile station being configured to follow the downlink signal frequency from the base station is that a reference clock generation circuit incorporated in a base station is more stable against changes in temperature and oscillation than a reference clock generation circuit incorporated in a mobile station. Thus, the stability of frequency in the entire system is enhanced.
Moreover, in PTL 2, a system is disclosed that is provided with a Doppler shift processor means apart from automatic frequency control as described above so that an accurate correction can be made even if the scope of frequency correction is broadened. In this system, a mobile station is configured to measure its moving velocity and location by using a GPS (Global Positioning System) receiver and calculate a frequency shift due to the Doppler effect, thereby controlling a voltage-controlled oscillator and adjusting a local oscillator frequency (see FIGS. 2 and 3 of PTL 2).

[Citation List]

[Patent Literature]

[PTL 1]
Japanese Patent Application Unexamined Publication No. 2001-157263

[PTL 2]
Japanese Patent Application Unexamined Publication No. 2001-119333

[Summary of Invention]

[Technical Problem]

However, a feedback system has an error in general. As changes over time in the frequency of a reception high-frequency signal become more rapid in particular, the ability of following the changes in frequency through the above-described frequency offset estimation decreases, resulting in a larger error. Hereinafter, a description will be given of the Doppler effect occurring when a mobile station passes a base station at high speed, as an example.

First, assuming that the frequency of a downlink signal transmitted by a base station is $f_o$ [Hz], a case will be considered where a mobile station is moving at velocity v [m/s] in a direction of angle θ viewed from the base station. In this case, the frequency $f_d$ [Hz] of electromagnetic waves arriving from the base station measured at the mobile station can be represented by the following equation in general.

[Math. 1]

$$f_d = \frac{\sqrt{1-(v/c)^2}}{1-(v/c)\cos\theta} f_o \qquad \cdots \quad (1)$$

Here, c is the velocity of light [m/s]. Assuming that θ = 0° when the mobile station is moving toward the base station, the frequency $f_d$ then measured can be represented by the following equation (2), by substituting θ = 0° into the equation (1).

[Math. 2]

$$f_d = \frac{\sqrt{1-(v/c)^2}}{1-(v/c)} f_o = \frac{\sqrt{1+(v/c)}}{\sqrt{1-(v/c)}} f_o \qquad \cdots \quad (2)$$

Here, if v << c, it is possible to make an approximation as follows.

[Math. 3]

$$\sqrt{1-(v/c)^2} \approx 1$$

Accordingly, the equation (2) can be approximated to the following equation (3).

[Math. 4]

$$f_d = \frac{\sqrt{1+(v/c)}}{\sqrt{1-(v/c)}} f_o = \frac{1+(v/c)}{\sqrt{1-(v/c)^2}} f_o \approx (1+v/c)f_o \qquad \cdots \quad (3)$$

That is, when the mobile station is approaching the base station at velocity v [m/s], the downlink signal frequency $f_d$ [Hz] from the base station measured at the mobile station can be obtained by the equation (3) due to the Doppler effect. In other words, since $f_o$ is the downlink signal frequency from the base station measured when the mobile station is stationary, if the mobile station is approaching the base station at high speed, the downlink signal frequency $f_d$ from the base station measured at the mobile station increases (up-shifts) by a frequency ratio of v/c compared to the downlink signal frequency $f_o$ at the time of stationary. As a result, the reference clock frequency in the mobile station correspondingly changes by the same frequency ratio of v/c, as in the above-described manner.

Next, when the mobile station passes the vicinity of the base station and moves away from the base station at velocity v [m/s], a downlink signal frequency $f_{d'}$ [Hz] measured at the mobile station, due to the Doppler effect, can be represented by the following equation (4), by substituting $\theta = 180\underline{o}$ into the equation (1) and applying similar approximation.

$$f_d' = (1 - v/c)f_o \qquad \cdots \quad (4)$$

That is, when the mobile station moves away from the base station at high speed, the downlink signal frequency $f_{d'}$ from the base station measured at the mobile station decreases (down-shifts) by the frequency ratio of v/c compared to the downlink signal frequency $f_o$ at the time of stationary. Accordingly, when the mobile station passes the base station at high speed, the frequency shift due to the Doppler effect abruptly changes from up-shift to down-shift. At this time, a frequency change amount $\Delta f_d$ measured at the mobile station is given by the following equation (5).

$$\Delta f_d = f_d' - f_d = -(2 \cdot v \cdot f_o)/c \qquad \cdots \quad (5)$$

Such a change in frequency becomes larger as the mobile station moves at higher speed, and an error of the feedback system trying to follow the change also becomes larger. As an error of a reference clock becomes larger, the error rate of received signals increases, which leads to a decrease in signal transmission throughput and a deterioration in communication quality, resulting in a disconnection occurring in the worst case.

It is possible to further increase the processing speed of a frequency offset estimation circuit so that such an abrupt change in reception frequency can be followed. However, increasing the processing speed of a circuit is not a desirable solution because it is accompanied with an increase in power consumption and heating value as well as a rise in cost.

Moreover, in PTL 2, adopted is a method in which the moving velocity and location of a mobile station are measured by using a GPS receiver and a Doppler shift is calculated, whereby a local oscillator signal is corrected. However, this Doppler shift is calculated by measuring the ever-changing current location and velocity of a mobile station, and a result of the calculation is reflected in a frequency oscillated by a voltage-controlled oscillator. This is feedback control similar to the frequency offset estimation. Additionally, PTL 2 considers only a case where a mobile station moves closer to or away from a base station. Therefore, the configuration that simply calculates a Doppler shift by using GPS and feedback-controls a voltage-controlled oscillator cannot follow an abrupt change in frequency made when a mobile station passes the vicinity of a base station at high speed as in the above-described equation (3).

The present invention is made in the light of the foregoing circumstances, and an object thereof is to provide a mobile communication device and a frequency control method for the device that can have an internal reference frequency follow a change in reception frequency even when the reception frequency changes abruptly.

[Solution to Problem]

A mobile radio communication system according to the present invention is a mobile radio communication system including a mobile station and a stationary base station, characterized in that the base station transmits a high-frequency signal to the mobile station, and the mobile station predicts a frequency change in the reception high-frequency signal received from the base station based on mobile environment information on the mobile station provided from outside and controls a frequency of a local oscillator signal based on a prediction result.

A mobile radio communication device according to the present invention is a mobile communication device in a mobile radio communication system including at least one stationary base station, characterized by comprising: a transmission and reception means for performing radio communication with the base station; and a control means that predicts a frequency change in a reception high-frequency signal received from the base station based on mobile environment information provided from outside and controls a frequency of a local oscillator signal of the transmission and reception means based on a prediction result.

A frequency control method according to the present invention is a frequency control method for a mobile communication device performing radio communication with a stationary base station, characterized by comprising: by a transmission and reception means, receiving a high-frequency signal from the base station; and by a control means, predicting a frequency change in the reception high-frequency signal received from the base station based on mobile environment information provided from outside and controlling a frequency of a local oscillator signal of the transmission and reception means based on a prediction result.

[Advantageous Effects of Invention]

According to the present invention, it is possible that the internal reference frequency of a mobile communication device follows a change in reception frequency even when the reception frequency changes abruptly.

[Brief Description of Drawings]

[Fig. 1]
FIG. 1 is a schematic block diagram showing an example of a transceiver section in a general CDMA mobile telephone device.
[Fig. 2]

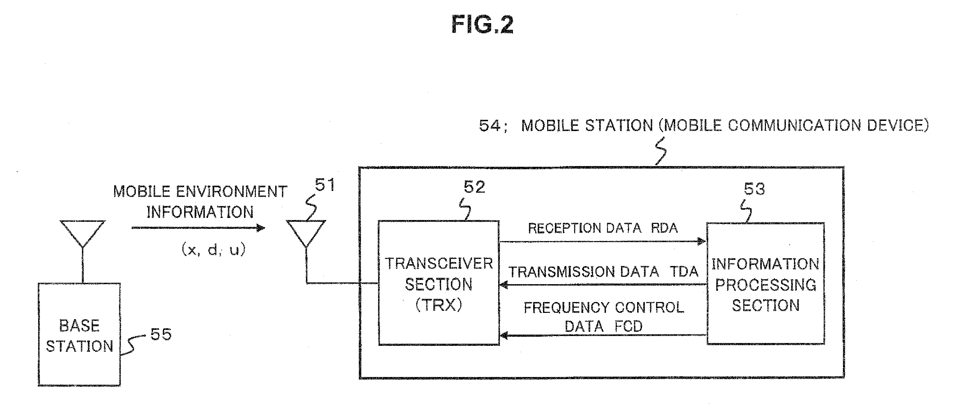

FIG. 2 is a block diagram showing the schematic structure of a mobile radio communications system including a mobile communication device (mobile station) according to a first exemplary embodiment of the present invention.
[Fig. 3]

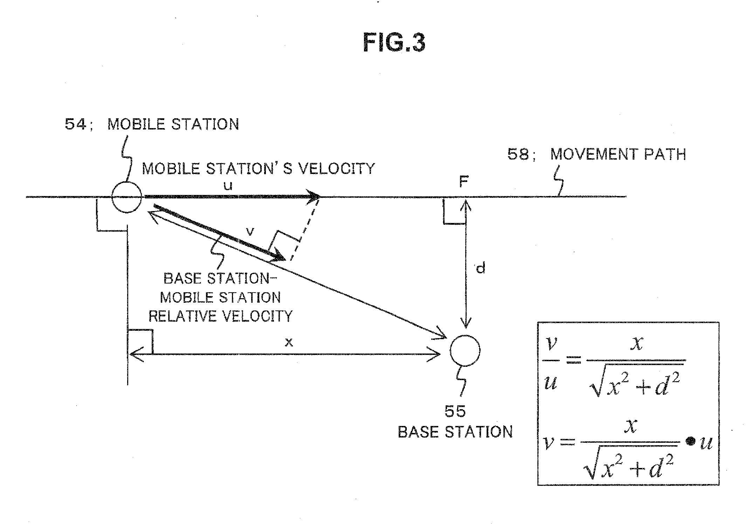

FIG. 3 is an explanatory diagram for calculation of mobile station-base station relative velocity in the first exemplary embodiment of the present invention.
[Fig. 4]

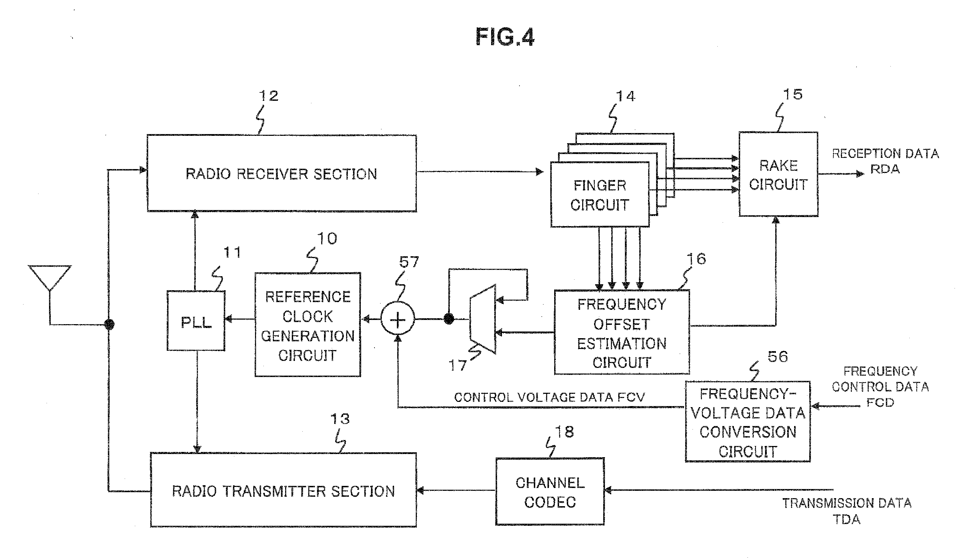

FIG. 4 is a block diagram showing the schematic functional configuration of a transceiver section in a mobile communication device according to a first example of the present invention.
[Fig. 5]

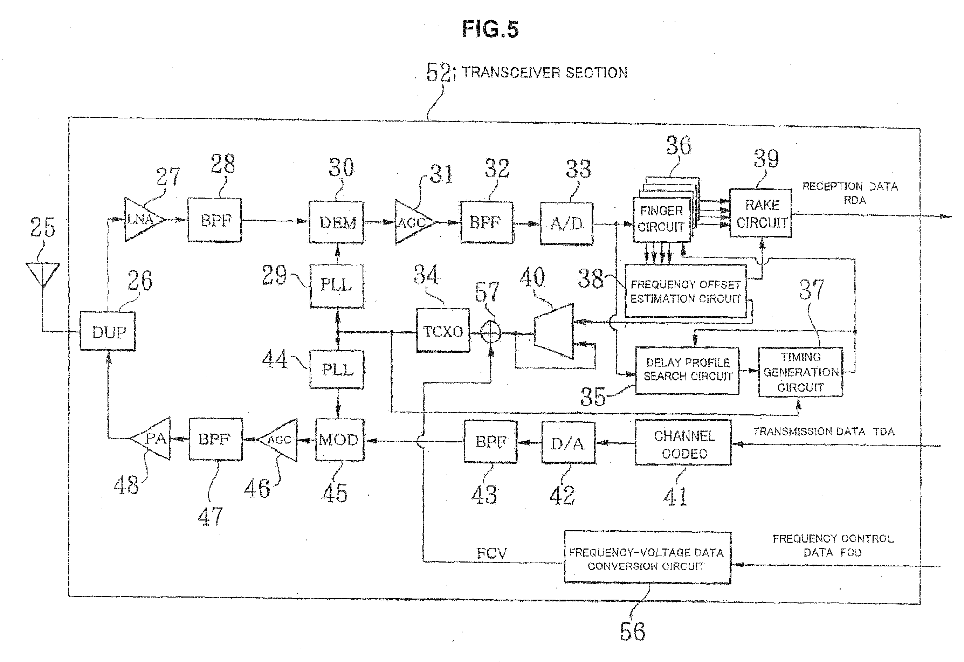

FIG. 5 is a block diagram showing the detailed functional configuration of the transceiver section in the mobile communication device according to the first example of the present invention.
[Fig. 6]

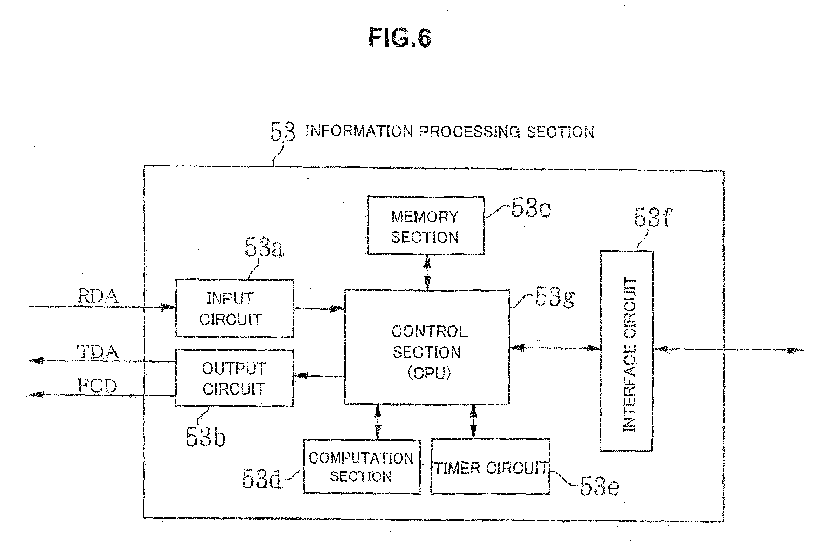

FIG. 6 is a block diagram showing the detailed functional configuration of an information processing section in the mobile communication device shown in FIG. 5.
[Fig. 7]

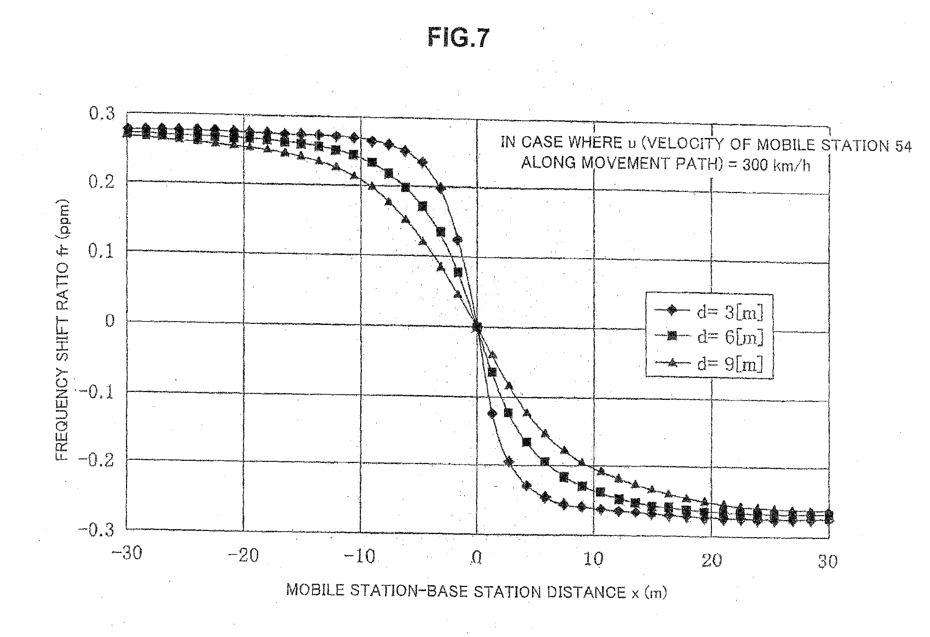

FIG. 7 is a graph showing changes in frequency shift ratio $f_r$ with respect to base station-mobile station in-movement-path-direction distance x.
[Fig. 8]

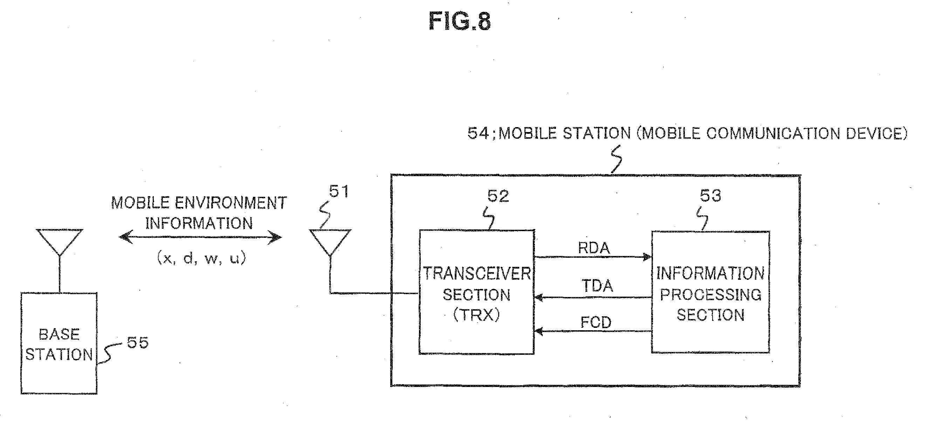

FIG. 8 is a block diagram of a mobile radio communications system including a mobile communication device (mobile station) according to a second exemplary embodiment of the present invention.
[Fig. 9]

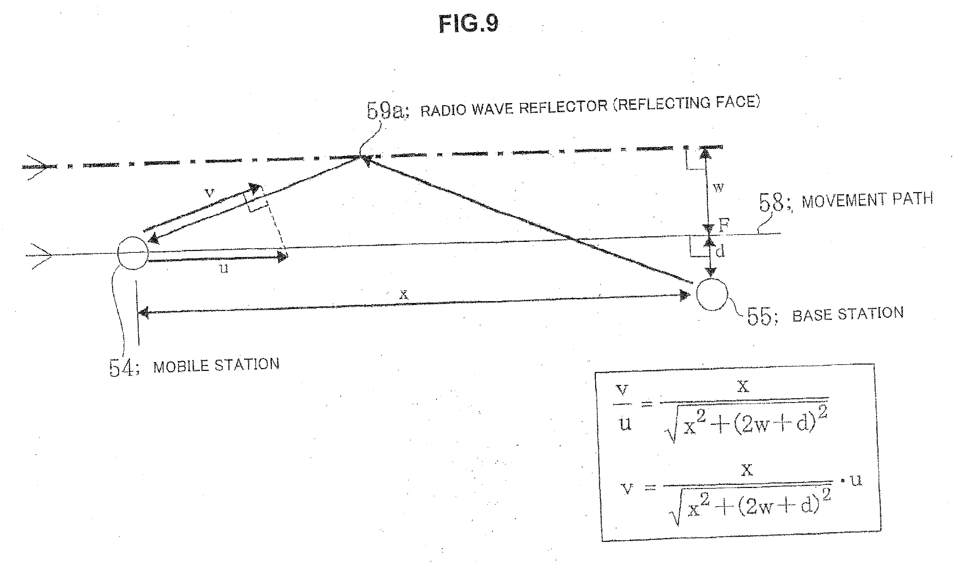

FIG. 9 is an explanatory diagram for calculation of mobile station-base station along-propagation-path relative velocity according to a first example of the placement of the mobile station and base station, in the second exemplary embodiment of the present invention.
[Fig. 10]

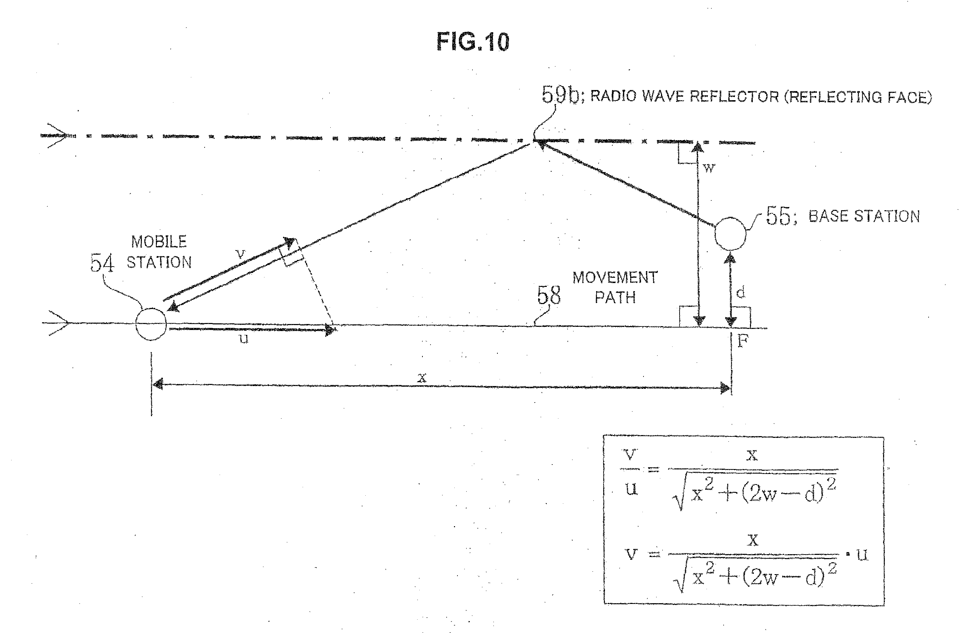

FIG. 10 is an explanatory diagram for calculation of the mobile station-base station along-propagation-path relative velocity according to a second example of the placement of the mobile station and base station, in the second exemplary embodiment of the present invention.
[Fig. 11]

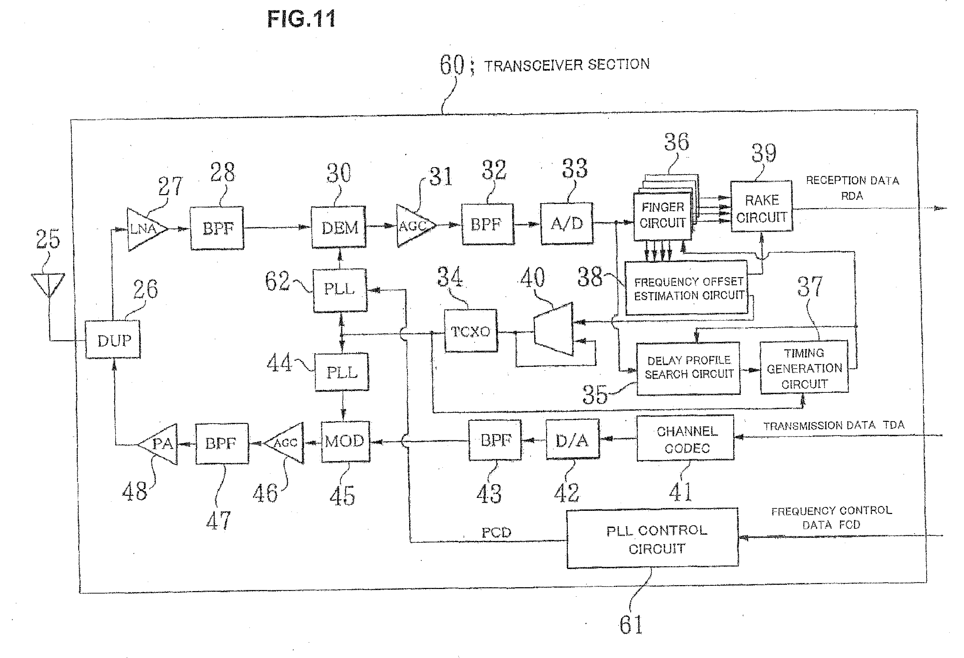

FIG. 11 is a block diagram showing the detailed functional configuration of a transceiver section in a mobile communication device according to a second example of the present invention.
[Fig. 12]

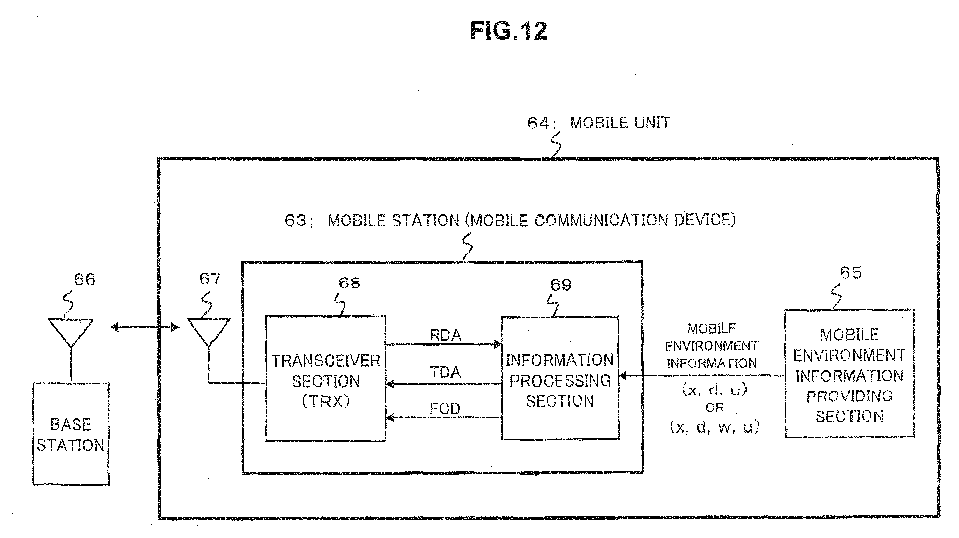

FIG. 12 is a block diagram of a mobile radio communications system including a mobile communication device (mobile station) according to a third exemplary embodiment of the present invention.
[Fig. 13]

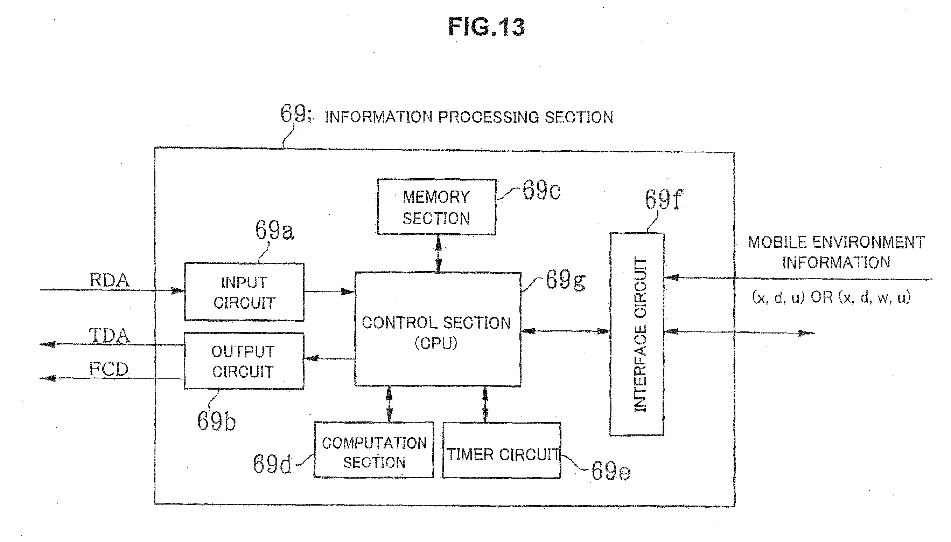

FIG. 13 is a block diagram showing the detailed functional configuration of an information processing section in the mobile communication device shown in FIG. 12.

[Description of Embodiments]

According to the present invention, mobile environment information is acquired from outside, and a forthcoming change in frequency is estimated based on that information, whereby predictive control of a local oscillator signal frequency is performed. The mobile environment information is provided from a base station (FIGS. 2 and 8) or from a vehicle with a mobile communication device mounted thereon (FIG. 12). Hereinafter, embodiments of the present invention will be described in detail.

1. First exemplary embodiment

First, a brief description will be given of the entire structure of a system with reference to FIGS. 2 and 3. It is assumed that a mobile radio communications system according to the present embodiment generally includes a mobile communication device 54 (hereinafter, referred to as mobile station 54) and a base station 55 which is fixedly installed on the ground and is stationary, as shown in FIG. 2. The mobile station 54 is mobile communication equipment such as a mobile telephone terminal and includes an antenna 51, a transceiver section (TRX) 52, and an information processing section 53.

The base station 55 transmits mobile environment information (x, d, u) on the mobile station 54 to the mobile station 54 by using a downlink high-frequency signal (radio signal). The mobile environment information (x, d, u) is location information and velocity information required for the mobile station 54 to obtain its velocity v relative to the base station 55. A specific example of the mobile environment information (x, d, u) will be described with reference to FIG. 3.

Referring to FIG. 3, it is assumed that the mobile station 54 is moving at velocity u along a movement path 58 and that the base station 55 is installed at distance d from the movement path 58. In this case, of the mobile environment information (x, d, u), x is the distance at the current point of time along the movement path 58, d is the distance from the base station 55 to the nearest point F on the movement path 58, and u is the mobile station's velocity at the current point of time along the movement path 58.

If the mobile station 54 is moving by train along a railroad, x is the distance from the current location of the train to the nearest point F on the railroad from the base station 55 that is fixedly installed beside the railroad, d is the distance from the base station 55 to the point F on the railroad, and u is the traveling velocity of the train. In general, railroads have railroad traffic control systems, which keep track of movement information on trains. Accordingly, the base station 55 can acquire the movement information on a train carrying the mobile station 54 from the railroad traffic control system and transmit that movement information to the mobile station 54 as the mobile environment information (x, d, u) on the mobile station 54.

If the mobile station 54 is moving by vehicle along a roadway, x is the distance from the current location of the vehicle to the nearest point F on the roadway from the base station 55 that is fixedly installed beside the roadway, d is the distance from the base station 55 to the point F on the roadway, and u is the traveling velocity of the vehicle. Roadways have moving vehicle monitoring systems, which recognize moving vehicles and detect their velocities. Accordingly, the base station 55 can acquire the movement information on a vehicle carrying the mobile station 54 from the moving vehicle monitoring system and transmit that movement information to the mobile station 54 as the mobile environment information (x, d, u) on the mobile station 54.

The transceiver section 52 of the mobile station 54, upon receiving a downlink high-frequency signal from the base station 55 through the antenna 51, demodulates the downlink high-frequency signal using an under-mentioned reception local oscillator signal and outputs reception data RDA containing the mobile environment information (x, d, u) to the information processing section 53. The information processing section 53 extracts the mobile environment information (x, d, u) from the reception data RDA and, based on the extracted mobile environment information (x, d, u), calculates the base station-mobile station relative velocity v. Using this relative velocity v, the information processing section 53 not only estimates the current frequency of the reception high-frequency signal but also estimates a forthcoming change in frequency, generates frequency control data FCD, and outputs it to the transceiver section 52 when appropriate.

The transceiver section 52, using a control signal corresponding to the frequency control data FCD, changes the frequency of the local oscillator signal controlled through a frequency offset estimation function feedback system. The frequency control data FCD includes also the estimation of a forthcoming change in frequency. Therefore, even if an abrupt change occurs in the frequency of the downlink high-frequency signal from the base station 55, the reference clock of the mobile station 54 can sufficiently follow the change.

2. First example

Hereinafter, the transceiver section 52 and the information processing section 53 will be described by illustrating a CDMA mobile communication terminal as a mobile communication device according to a first example of the present invention.

2.1) Transceiver section

As schematically shown in FIG. 4, the mobile communication terminal according to the present example has a configuration additionally including a voltage data conversion circuit 56 and an adder 57 in comparison with the mobile communication terminal shown in FIG. 1. Accordingly, those blocks that have the same functions as the circuits shown in FIG. 1 are denoted by the same reference numerals as in FIG. 1. Hereinafter, the entire configuration will be described.

A reference clock generation circuit 10 generates a reference clock serving as a reference for the operation timing of the entire device and is a voltage-controlled oscillator using a temperature-compensated crystal oscillator (TCXO), for example. Using the reference clock generated by the reference clock generation circuit 10 as a reference frequency, a PLL (Phase-Locked Loop) circuit 11 generates required local oscillator signals and outputs them to a radio receiver section 12 and a radio transmitter section 13, respectively.

The radio receiver section 12 performs down-conversion and quadrature demodulation on a reception high-frequency signal by using the local oscillator signal for down-conversion and for quadrature demodulation and outputs a reception digital baseband signal to a finger circuit 14. The finger circuit 14 outputs, for each finger, a demodulated signal of the reception digital baseband signal to a RAKE circuit 15 and pilot data to a frequency offset estimation circuit 16. The RAKE circuit 15 synthesizes the demodulated signals weighted using frequency offset amounts input from the frequency offset estimation circuit 16, thereby generating reception data RDA and outputting it to the information processing section 53.

The frequency offset estimation circuit 16 estimates the reception -frequency offsets based on the pilot data input from each finger and outputs them to the RAKE circuit 15. In addition, the frequency offset estimation circuit 16 also outputs a frequency offset amount synthesized from these offsets to an accumulator circuit 17. The accumulator circuit 17 outputs the value of an accumulation of such synthesized frequency offset amounts, as control voltage data, to a control terminal of the reference clock generation circuit 10 through the adder 57.

The voltage data conversion circuit 56 converts frequency control data FCD input from the information processing section 53 into corresponding control voltage data FCV and outputs it to the adder 57. The adder 57 adds the control voltage data obtained through the frequency offset estimation, which is input from the accumulator circuit 17, and the control voltage data FCV corresponding to the frequency control data, which is input from the voltage data conversion circuit 56, and outputs a result of the addition, as frequency control voltage data, to the control terminal of the reference clock generation circuit 10.

A reference clock frequency to be thus output from the reference clock generation circuit 10 includes not only automatic control according to the frequency offset estimation but also predictive control of a frequency change estimated by the information processing section 53. Accordingly, it is possible to follow an abrupt change in reception frequency occurring when the mobile station passes the base station at high speed. The local oscillator signal for down-conversion and for quadrature demodulation is generated in accordance with the thus controlled reference clock and output to the radio receiver section 12. Similarly, the local oscillator signal for up-conversion and for quadrature modulation is generated in accordance with the controlled reference clock and output to the radio transmitter section 13. Incidentally, transmission data is encoded through a predetermined scheme by a channel codec 18 and output to the radio transmitter section 13. Hereinafter, the more detailed configuration of the transceiver section 52 will be described with reference to FIG. 5.

Referring to FIG. 5, a reception circuit section of the above-described mobile station 54 is mainly composed of a low noise amplifier 27, a band-pass filter 28, a PLL circuit 29, a quadrature demodulator 30, an automatic gain control (AGC) amplifier 31, a band-pass filter 32, an A/D converter 33, a reference clock generation circuit 34, a delay profile search circuit 35, a finger circuit 36, a timing generation circuit 37, a frequency offset estimation circuit 38, a RAKE circuit 39, an accumulator circuit 40, a frequency-voltage data conversion circuit 56, and an adder 57. A transmission circuit section is mainly composed of the reference clock generation circuit 34 shared with the reception circuit section, a channel codec 41, a D/A converter 42, a band-pass filter 43, a PLL circuit 44, a quadrature modulator 45, an AGC amplifier 46, a band-pass filter 47, and a power amplifier 48.

The reference clock generation circuit 34 incorporated in the mobile station receives, at a control terminal, an input of control voltage data that is a result of addition performed by the adder 57 and generates a reference clock based on the control voltage data. The reference clock generation circuit 34 outputs the reference clock to each of the PLL circuit 29 at the side of the reception circuit section and the PLL circuit 44 at the side of the transmission circuit section and also provides it to the timing generation circuit 37. The reception circuit section-side PLL circuit 29 generates a local oscillator signal based on the input reference clock and outputs it to the quadrature demodulator 30. On the other hand, the transmission circuit section-side PLL circuit 44 generates a local oscillator signal based on the input reference clock and outputs it to the quadrature modulator 45.

From a downlink high-frequency signal received from the base station through an antenna 25, a signal in a required predetermined frequency band is selected by a duplexer 26 and led to the reception circuit section as a reception high-frequency signal. The reception high-frequency signal is first amplified by the low noise amplifier 27, further band-limited by the band-pass filter 28, and then input to the quadrature demodulator 30. The quadrature demodulator 30 performs quasi-synchronous demodulation of the reception high-frequency signal using the local oscillator signal provided by the PLL circuit 29 and generates a reception analog baseband signal. The reception analog baseband signal is level-controlled by the AGC amplifier 31, band-limited by the band-pass filter 32, and then input to the A/D converter 33. The A/D converter 33 converts the reception analog baseband signal into a reception digital baseband signal. The reception digital baseband signal is input to each of the delay profile search circuit 35 and the finger circuit 36. Here, the mobile station can estimate a reference clock of the base station based on pilot data, which has been generated in synchronization with the reference clock of the base station and superposed onto the reception digital baseband signal. This is equivalent to that the reference clock of the base station is superposed onto the reception digital baseband signal.

Moreover, the delay profile search circuit 35 generates a frame timing time-correction amount based on a frame timing signal generated by the timing generation circuit 37 and on the input reception digital baseband signal and outputs it to the timing generation circuit 37. The timing generation circuit 37 first generates an ideal frame timing signal based on the reference clock generated by the reference clock generation circuit 34 in the device and next adds the input frame timing time-correction amount to the generated ideal frame timing signal, thereby correcting the ideal frame timing signal. The corrected frame timing signal is input to each of the delay profile search circuit 35 and the finger circuit 36.

The finger circuit 36 is composed of a plurality of fingers for separating a reception digital baseband signal received through multipath into individual single-path components. Based on the input corrected frame timing signal, the finger circuit 36 demodulates the reception digital baseband signal for each finger and outputs them to the RAKE circuit 39. Further, the finger circuit 36 outputs pilot data contained in the reception digital baseband signal of each finger to the frequency offset estimation circuit 38 from each finger. The frequency offset estimation circuit 38 calculates a frequency offset amount for each finger based on the pilot data (synchronized with the reference clock of the base station) input from each finger and outputs them to the RAKE circuit 39. At the same time, the frequency offset estimation circuit 38 synthesizes the frequency offset amounts of the individual fingers by weighting and outputs a synthesized frequency offset amount to the accumulator circuit 40. The above-mentioned RAKE circuit 39 synthesizes the demodulated signals output from the individual fingers by weighting based on the input frequency offset amounts of the individual fingers, thereby generating reception data RDA. Thus, the reception data RDA from which fading is reduced can be obtained.

The accumulator circuit 40 adds the input synthesized frequency offset amount (frequency shift amount) and a current output value and outputs a result of this addition to the adder 57. Moreover, the frequency-voltage data conversion circuit 56 converts frequency control data FCD captured from the information processing section 53 into corresponding frequency control voltage data FCV and outputs it to the adder 57. The adder 57 adds the input output value of the accumulator circuit 40 and the input frequency control voltage data FCV and outputs a result of the addition to the reference clock generation circuit 34. The reference clock generation circuit 34 receives, at the frequency control terminal, an input of control voltage data that is the result of the addition by the adder 57 and generates a reference clock based on the control voltage data. That is, this is equivalent to having the reference clock of the mobile station 54 follow the reference clock of the base station 55. Thus, the reference clock generation circuit 34 outputs the reference clock following the reference clock of the base station 55 to each of the PLL circuit 29 of the reception circuit section, the PLL circuit 44 of the transmission circuit section, and the timing generation circuit 37.


2.2) Information processing section

Next, the configuration of the information processing section 53 included in the mobile station 54 will be described in detail with reference to FIG. 6. The information processing section 53 according to the present example generally includes, as shown in FIG. 6, an input circuit 53a, an output circuit 53b, a memory section 53c, a computation section 53d, a timer circuit 53e, an interface circuit 53f, and a control section (CPU) 53g that controls each section of the device.

The control section 53g of the information processing section 53 allows the input circuit 53a to receive an input of reception data RDA output from the RAKE circuit 39 of the transceiver section 52 and temporarily stores it in the memory section 53c. The control section 53g converts the reception data RDA into general reception information and mobile environment information (x, d, u) and outputs the general reception information through the interface circuit 53f. Moreover, upon receiving an input of general transmission information through the interface circuit 53f, the control section 53g generates transmission data TDA and outputs it to the transceiver section 52 from the output circuit 53b.

Further, in the information processing section 53, the computation section 53d, under control of the control section 53g, executes predictive computation regarding a frequency shift due to the Doppler effect based on the mobile environment information (x, d, u). The control section 53g sets a timing setting value on the timer circuit 53e to activate it and, based on timing information from the timer circuit 53e, allows frequency control data FCD obtained by the computation section 53d to be output from the output circuit 53b to the transceiver section 52 at an appropriate time.

Note that as to the above-described control section 53g and computation section 53d, equivalent functions can also be implemented by executing programs on a program-controlled processor such as a CPU.

2.3) Operation

Next, a description will be given of frequency control-related operation of the transceiver section 52 of the mobile station 54, with reference to FIG. 5.

The reference clock generation circuit 34 generates a reference clock and provides it to the reception circuit section-side PLL circuit 29 and to the transmission circuit section-side PLL circuit 44. The PLL circuits 29 and 44 each generates a local oscillator signal based on the input reference clock. The reception circuit section-side PLL circuit 29 outputs the generated local oscillator signal to the quadrature demodulator 30, while the transmission circuit section-side PLL circuit 44 outputs the generated local oscillator signal to the quadrature modulator 45.

Reception data RDA containing mobile environment information (x, d, u) received from the base station 55 is output to the information processing section 53. As described above, at the finger circuit 36, each finger extracts pilot data contained in a reception digital baseband signal and outputs it to the frequency offset estimation circuit 38. The frequency offset estimation circuit 38 calculates a frequency offset amount for each finger based on the pilot data input from each finger, synthesizes the frequency offset amounts of the individual fingers by weighting, and outputs a synthesized frequency offset amount to the accumulator circuit 40.

The accumulator circuit 40 adds the input synthesized frequency offset amount (frequency shift amount) and a current output value and outputs a result of this addition to the adder 57. Moreover, the frequency-voltage data conversion circuit 56 converts frequency control data FDC, which is predictive control data provided by the information processing section 53, into corresponding frequency control voltage data FCV by using a predetermined conversion formula or predetermined conversion table and outputs it to the adder 57. The adder 57 adds the input output value of the accumulator circuit 40 and the frequency control voltage data FCV and outputs a result of the addition to the reference clock generation circuit 34. The reference clock generation circuit 34 generates a reference clock based on the result of the addition by the adder 57 and outputs it to each of the PLL circuit 29 of the reception circuit section, the PLL circuit 44 of the transmission circuit section, and the timing generation circuit 37.

2.4) Prediction of a change in frequency

Next, a description will be given of an operation of generating the frequency control data FCD in the information processing section 53 of the mobile station 54, with reference to FIGS. 3, 6, and 7. First, the control section 53g of the information processing section 53 obtains the base station-mobile station relative velocity v [m/s] from the mobile environment information (x, d, u) extracted from the reception data RDA. The base station-mobile station relative velocity v [m/s] can be obtained by an equation (6) where the base station-mobile station in-movement-path-direction distance x [m], base station-movement path distance d [m], and mobile station's along-movement-path velocity u [m/s] are variables.

[Math. 5]

$$v = \frac{x}{\sqrt{x^2 + d^2}} \bullet u \qquad \cdots \quad (6)$$

Here, it is assumed that the base station 55 transmits a downlink high-frequency signal at frequency $f_o$ [Hz] and that the mobile station 54 is moving toward the base station 55 at velocity v [m/s]. At this time, assuming that the velocity of light is c [m/s], the frequency $F_d$ [Hz] of the downlink high-frequency signal from the base station 55 measured at the mobile station 54 is given by the equation (3) due to the Doppler effect, as described already.

$$f_d = (1 + v/c) f_o \qquad \cdots \quad (3)$$

When this apparent frequency $f_d$ of the downlink high-frequency signal is calculated, a frequency shift $f_s$ due to the Doppler effect is given by the following equation (7), and frequency shift ratio $f_r$ is given by the following equation (8).

$$f_s = f_d - f_o = (v/c) f_o \qquad \cdots \quad (7)$$

$$f_r = (f_d - f_o)/f_o = (v/c) \qquad \cdots (8)$$

Moreover, the frequency $f_{d'}$ that will be measured when the mobile station 54 passes the vicinity of the base station 55 and the movement thereof changes from approaching to receding (that is, when an abrupt change occurs in the carrier frequency of the reception high-frequency signal) can be obtained by using the equation (4), and the frequency change amount $\Delta f_d$ made when a forthcoming abrupt change in frequency occurs can be predicted by using the equation (5), as described already.

$$f_d' = (1 - v/c)f_o \qquad \cdots (4)$$

$$\Delta f_d = f_d' - f_d = -(2 \cdot v \cdot f_o)/c \qquad \cdots (5)$$

For reference, FIG. 7 is a graph showing changes in the frequency shift ratio $f_r$ with respect to the base station-mobile station in-movement-path-direction distance x. Specifically, this shows changes in the frequency shift ratio $f_r$ (ppm) with respect to the distance x [m] of the mobile station 54 from the base station in the movement path direction when the mobile station's velocity u along the movement path 58 is 300 km/h, by using the base station-movement path distance d [m] as a parameter.

The computation section 53d of the information processing section 53 estimates, by using the above-described arithmetic equations, how the current reception high-frequency signal's frequency will change and returns a result of the computation to the control section 53g as frequency control data FCD. The control section 53g outputs the frequency control data FCD to the transceiver section 52 at an appropriate time. The control section 53g sets the timer circuit 53e for a time, as a timing setting value, to output the frequency control data FCD, which corresponds to the frequency control data FCD and has been estimated by the computation section 53d and, when the set time has arrived, outputs the frequency control data FCD obtained by the computation section 53d to the transceiver section 52 through the output circuit 53b. Thus, when an abrupt change in frequency is occurring during a period when the frequency may change abruptly, it is possible to output frequency control voltage data FCV to the adder 57 so that the frequency after the abrupt change will be followed.

The above-described computation of the frequency shift $f_s$ can be performed before the mobile station 54 passes the vicinity of the base station 55. Therefore, before the mobile station 54 passes the vicinity of the base station 55, the information processing section 53 of the mobile station 54 can predict the reception high-frequency signal frequency $f_d$ and frequency shift $f_s$ that will be measured immediately after the mobile station 54 passes the vicinity of the base station 55.

For the transceiver section 52 of the mobile station 54, it is desirable that the frequency of the local oscillator signal output by the PLL circuit 29 (see FIG. 5) be equal to the carrier frequency of the reception high-frequency signal. The information processing section 53 generates beforehand, through the above-described computation, the frequency control data FCD corresponding to the reception high-frequency signal frequency predicted to be measured immediately after the mobile station 54 passes the vicinity of the base station. When the mobile station 54 is actually passing the vicinity of the base station, the information processing section 53 outputs the frequency control data FCD to the frequency-voltage data conversion circuit 56 of the transceiver section 52, and the frequency-voltage data conversion circuit 56 converts the frequency control data FCD into the frequency control voltage data FCV and outputs it to the adder 57.

Here, the frequency control data FCD and frequency control voltage data FCV correspond to the predicted frequency change amount (frequency shift difference) $\Delta f_d$ due to the Doppler effect. Since the reference clock generation circuit 34 generates a reference clock by receiving an output of addition by the adder 57 as control voltage, its oscillation frequency reflects the reception high-frequency signal frequency affected by the Doppler effect occurring when (immediately after) the mobile station 54 passes the vicinity of the base station. Accordingly, the frequency of the local oscillator signal generated by the PLL circuit 29 based on the oscillation frequency of the reference clock also reflects the reception high-frequency signal frequency affected by the Doppler effect.

2.5) Effects

As described above, according to the present example, even in an environment where a change in frequency occurs at high speed due to the Doppler effect, the frequency of the local oscillator signal output by the PLL circuit 29 can be following-controlled smoothly so as to be equal to the carrier frequency of the reception high-frequency signal affected by the Doppler effect. Thus, an error of the feedback system included in the frequency offset estimation functionality can be made small, and the signal error rate and the probability of signal disconnection can be reduced. Accordingly, even when the mobile station has passed the vicinity of the base station and the movement thereof has changed from approaching to receding (that is, when an abrupt change has occurred in the carrier frequency of the reception high-frequency signal), it is possible to avoid decrease in the signal transmission throughput and degradation in the communication quality.

Moreover, the mobile station 54 according to the present example can perform predictive control regarding a frequency shift due to the Doppler effect occurring when (immediately after) the mobile station 54 passes the vicinity of the base station, based on the mobile environment information provided beforehand. Accordingly, the transceiver section 52 of the mobile station 54 can have the frequency of the local oscillator signal accurately follow the carrier frequency of the reception high-frequency signal, without dependence on the speedup of the frequency offset estimation circuit 38. Accordingly, a complex and expensive high-speed circuit configuration is not required, and the frequency offset estimation functionality can be implemented with an inexpensive and simple low-speed circuit configuration, whereby the circuits can operate with low power consumption and further the heating value can also be suppressed.

3. Second exemplary embodiment

In a second exemplary embodiment of the present invention, the influence of a radio wave reflector on the Doppler effect is taken into consideration. Hereinafter, a mobile radio communications system according to the second exemplary embodiment of the present invention will be described with reference to FIGS. 8 to 10.

3.1) Configuration

The different point of the system according to the second exemplary embodiment from the above-described first embodiment is that information about distance w from a movement path 58 to a reflecting face of a radio wave reflector (hereinafter, also simply referred to as movement path-radio reflector distance) is further added into the mobile environment information (x, d, u) of the first exemplary embodiment. Specifically, in this second exemplary embodiment, mobile environment information (x, d, u, w) is used with consideration given to a case where a radio wave reflector 59a or 59b exists in the vicinity of the movement path 58, as shown in FIGS. 9 and 10. The second exemplary embodiment is approximately similar to the above-described first exemplary embodiment in the other points than the existence of the radio wave reflector (reflecting face) 59a or 59b and the accordingly introduced movement path-radio reflector distance w. Therefore, in FIGS. 8 to 10, the same reference numerals are used as in FIGS. 2 and 3, and a description thereof will be omitted or simplified. Moreover, since the circuit configuration of a transceiver section 52 of a mobile station 54 is also similar to the configuration shown in FIG. 5, a description will be given with reference to the circuit in FIG. 5 as well when appropriate.

In a case where the mobile station 54 is moving by train along a railroad, the movement path-radio reflector distance w, for example, corresponds to the distance between the railroad and a tunnel inwall (radio wave reflecting face) when inside a railroad tunnel, or corresponds to the distance between the railroad and a sound barrier (radio wave reflecting face) when in an area where the sound barrier is built. Since information about such distances between a railroad and radio wave reflecting faces is already-known information as railroad management information, a detailed description of the acquisition of the information will be omitted.

Moreover, in a case where the mobile station 54 is moving by vehicle along a roadway, the movement path-radio reflector distance w, for example, corresponds to the distance between a vehicle traveled way and a tunnel inwall (radio wave reflecting face) when inside a roadway tunnel, or corresponds to the distance between a vehicle traveled way and a sound barrier (radio wave reflecting face) when in an area where the sound barrier is built. Since information about such distances between a movement path and radio wave reflecting faces is already-known information as traffic management information or road management information, a detailed description of the acquisition of the information will be omitted.

3.2) Operation

Next, a description will be given of an operation of following a change in frequency caused by the Doppler effect performed by the mobile station 54 according to the present exemplary embodiment, with reference to FIGS. 8 to 10.

In the mobile station 54 according to the present exemplary embodiment, upon receiving a downlink high-frequency signal containing mobile environment information (x, d, u, w) from the base station 55, demodulation processing is performed by the demodulator 30 as described above, and thereafter reception data RDA is output from the RAKE circuit 39 to the information processing section 53. The information processing section 53 extracts the mobile environment information (x, d, u, w) from the reception data RDA and recognizes the base station-mobile station in-movement-path-direction distance x, base station-movement path distance d, mobile station's along-movement-path velocity u, and further movement path-radio reflector distance w when the radio wave reflector (reflecting face) 59a or 59b exists in the vicinity of the movement path 58. The information processing section 53 also recognizes whether the radio wave reflector exists on the opposite side to the base station 55 (the radio wave reflector 59a in FIG. 9) or on the same side as the base station 55 (the radio wave reflector 59b in FIG. 10) relative to the movement path 58 of the mobile station 54.

The information processing section 53 obtains the relative velocity v [m/s] between the base station and mobile station along a propagation path from the mobile environment information (x, d, u, w) extracted from the reception data RDA. The base station-mobile station along-propagation-path relative velocity v [m/s] can be obtained by the following equation (9) or (10) where the base station-mobile station in-movement-path-direction distance x [m], base station-movement path distance d [m], mobile station's along-movement-path velocity u [m/s], and movement path-radio reflector distance w [m] are variables.

When recognizing that the radio wave reflector 59a exists along the movement path 58 on the opposite side to the base station 55 relative to the movement path 58 as shown in FIG. 9, the information processing section 53 calculates the base station-mobile station along-propagation-path relative velocity v [m/s] by using the equation (9).

[Math. 6]

$$v = \frac{x}{\sqrt{x^2 + (2w+d)^2}} \bullet u \qquad \cdots \quad (9)$$

On the other hand, when recognizing that the radio wave reflector 59b exists along the movement path 58 on the same side as the base station 55 relative to the movement path 58 as shown in FIG. 10, the information processing section 53 calculates the base station-mobile station along-propagation-path relative velocity or [m/s] by using the equation (10).

[Math. 7]

$$v = \frac{x}{\sqrt{x^2 + (2w-d)^2}} \bullet u \qquad \cdots \quad (10)$$

When the base station-mobile station along-propagation-path relative velocity v [m/s] is calculated, the downlink high-frequency signal frequency $f_d$ from the base station 55 measured at the mobile station 54, the frequency shift $f_s$ due to the Doppler effect, and the frequency shift ratio $f_r$ can be derived from the equations (3), (7), and (8), respectively. Moreover, the (moving-away) frequency $f_{d'}$ that will be measured when the mobile station 54 passes the vicinity of the base station 55 and the movement thereof changes from approaching to moving-away (that is, when an abrupt change occurs in the carrier frequency of the reception high-frequency signal) and the frequency change amount (forthcoming frequency change amount) $\Delta f_d$ can be predicted by using the equations (4) and (5), respectively.

In this manner, according to the present exemplary embodiment, the information processing section 53 of the mobile station 54 can generate frequency control data FCD in which a radio wave reflector is taken into consideration and output it to the transceiver section 52 at an appropriate time.

Note that functions equivalent to the information processing section 53 can also be implemented by executing a program on a program-controlled processor such as a CPU.

4. Third exemplary embodiment

4.1) Configuration

The above-described first and second exemplary embodiments adopt a configuration in which the adder 57 is provided between the frequency control terminal of the reference clock generation circuit 34 and the output of the accumulator circuit 17 as shown in FIG. 5 and the frequency control voltage data FCV corresponding to a predicted frequency change amount is added thereto.

On the other hand, in a third exemplary embodiment of the present invention, the frequency control data FCD corresponding to a predicted frequency change amount is converted into a signal directly controlling a PLL circuit, and the signal is output to the PLL circuit that generates a receiving-side local oscillator signal.

Specifically, the frequency control functionality implemented by the voltage data conversion circuit 56, adder 57, and reception circuit-side PLL circuit 29 in FIG. 5, that is, the frequency control performed when the mobile station 54 passes the vicinity of the base station, is implemented by a PLL control circuit 61 and a PLL circuit 62 in FIG. 11. Since the other configuration is similar to that shown in FIG. 5, the same reference numerals are used, and a description thereof will be omitted or simplified.

Referring to FIG. 11, in a transceiver section 60 of a mobile station according to the present embodiment, a reference clock generated by the reference clock generation circuit 34 is output to the PLL circuit 62 on the reception circuit side and to the PLL circuit 44 on the transmission circuit side. The PLL circuit 62 generates a local oscillator signal based on the reference clock and outputs it to the quadrature demodulator 30. Moreover, frequency control data FCD from the information processing section is converted by the PLL control circuit 61 into PLL control data PCD, which it then output to the PLL circuit 62.

4.2) Operation

Next, operation of the transceiver section 60 of the present embodiment will be described with reference to FIG. 11. Frequency control data FCD input from the information processing section is converted by the PLL control circuit 61 into PLL control data PCD, which is input to the reception circuit-side PLL circuit 62. Based on the PLL control data PCD, the PLL circuit 62 determines the frequency of a local oscillator signal to output to the quadrature demodulator 30. Specifically, a frequency-dividing number of a frequency divider included in the PLL circuit 62 is configured to depend on the value of the PLL control data PCD, whereby the frequency of a local oscillator signal to be output can be determined. Accordingly, the transceiver section 60 can implement frequency-capturing and frequency-following functions similar to those of the transceiver section 52 (FIG. 5) described in the first embodiment.

Moreover, similar functions to those described above can also be implemented by making a configuration, as a means of controlling the frequency of the PLL circuit 62, such that the PLL control data PCD is converted into an analog voltage by a D/A converter (not shown), and the value of this analog voltage is added to control voltage for a voltage-controlled oscillator (VCO) in the PLL circuit by using an adder (not shown).

5. Fourth exemplary embodiment

Although the mobile environment information is provided from the base station in the above-described first to third exemplary embodiments, the present invention is not limited to this configuration. It is also possible to acquire the mobile environment information from a vehicle with a mobile station mounted thereon, which will be described next.

Referring to FIG. 12, in a mobile radio communications system according to this exemplary embodiment, a mobile unit 64 such as a train or vehicle with a mobile station 63 mounted thereon is provided with a mobile environment information providing section 65. Specifically, in this embodiment, the mobile environment information is not contained in a downlink high-frequency signal from a base station 66 as the reception high-frequency signal, and a configuration is made such that the mobile environment information (x, d, u) or (x, d, u, w) regarding the mobile station 63 is provided instead from the mobile environment information providing section 65 included in the mobile unit 64 to the mobile station 63.

The mobile station 63 includes an antenna 67 for performing radio communication with the base station 66, a transceiver section 68, and an information processing section 69 as shown in FIG. 12 and moves along a movement path such as a railroad or roadway by being mounted on the mobile unit 64. The mobile environment information providing section 65 has mobile environment information (x, d, u) or (x, d, u, w) on the mobile unit 64, or acquire the mobile environment information from a traffic management system or the like managing the mobile unit 64, and outputs it to the information processing section 69 of the mobile station 63. The information processing section 69 of the mobile station 63 generates frequency control data FCD based on the input mobile environment information (x, d, u) or (x, d, u, w) as described already and outputs it to the transceiver section 68. According to this configuration, it can be thought that the location information x and velocity information u on the mobile unit 64 (mobile environment information providing section 65) are the location information x and velocity information u on the mobile station 63, respectively.

Next, the information processing section 69 included in the mobile station 63 will be described in detail with reference to FIG. 13. The information processing section 69 of the mobile station 63 according to the present embodiment generally includes an input circuit 69a, an output circuit 69b, a memory section 69c, a computation section 69d, a timer circuit 69e, an interface circuit 69f and a control section (CPU) 69g that controls each section of the device.

The control section 69g of the information processing section 69 allows the input circuit 69a to receive an input of reception data RDA from the transceiver section 68 and temporarily stores it in the memory section 69c. Moreover, the control section 69g converts the reception data RDA into general received information and then outputs the obtained reception information through the interface circuit 69f. In addition, upon receiving general transmission information through the interface circuit 69f, the control section 69g generates transmission data TDA and outputs it to the transceiver section 68 from the output circuit 69b.

Further, upon receiving an input of the mobile environment information (x, d, u) or (x, d, u, w) from the mobile environment information providing section 65 through the interface circuit 69f, the control section 69g executes predictive computation regarding a frequency shift due to the Doppler effect based on the mobile environment information and thereby generates frequency control data (control information) FCD. At this time, the control section 69g sets a timing setting value onto the timer circuit 69e, whereby the frequency control data FCD is output from the output circuit 69b to the transceiver section 68 at an appropriate time in accordance with timing information from the timer circuit 69e.

A description will be given of operation performed when the mobile station 63 is moving by train along a railroad. A railroad traffic management system, which has location information and velocity information on individual trains in general, has location information on the base station 66 placed along the railroad as well here. In the present embodiment, the railroad traffic management system can also have location information on a radio wave reflector such as a tunnel or sound barrier as needed. The above-described traffic management system generates mobile environment information (x, d, u) or (x, d, u, w) on a train (the mobile unit 64 in FIG. 12) based upon the velocity information, location information on various objects, and the like and transmits it to the corresponding train (mobile unit 64). Upon receiving the mobile environment information from the traffic management system, the train (mobile unit 64) temporarily stores it in the mobile environment information providing section 65. The mobile environment information providing section 65 transmits the temporarily stored mobile environment information to the information processing section 69 of the mobile station 63 mounted on the train. The information processing section 69 of the mobile station 63 generates frequency control data FCD based on the provided mobile environment information and outputs it to the transceiver section 63 of the mobile station 63. In this manner, functions of predicting a change in frequency and correspondingly controlling frequency that are approximately similar to those described in the first embodiment (FIGS. 5 and 6) can be implemented.

A description will be given of operation performed when the mobile station 63 is moving by vehicle along a roadway. A car navigation system, which has location information and velocity information on individual vehicles in general, has location information on the base station 66 placed along the roadway as well here. In the present exemplary embodiment, the car navigation system can also have location information on a radio wave reflector such as a tunnel or sound barrier as needed. The above-described car navigation system generates mobile environment information (x, d, u) or (x, d, u, w) on a vehicle (the mobile unit 64 in FIG. 12) based upon the velocity information, location information on various objects, and the like and transmits it to the corresponding vehicle (mobile unit 64). The vehicle (mobile unit 64) temporarily stores the mobile environment information received from the car navigation system in the mobile environment information providing section 65. The mobile environment information providing section 65 transmits the temporarily stored mobile environment information to the information processing section 69 of the mobile station 63 (mounted on the vehicle). The information processing section 69 of the mobile station 63 generates frequency control data FCD based on the provided mobile environment information and outputs it to the transceiver section 63 of the mobile station 63. In this manner, functions of predicting a change in frequency and correspondingly controlling frequency that are approximately similar to those described in the first embodiment (FIGS. 5 and 6) can be implemented.

Note that as to the above-described control section 69g and computation section 69d, equivalent functions can also be implemented by executing programs on a program-controlled processor such as a CPU.

Hereinabove, embodiments of the present invention have been described with reference to the drawings. However, specific configurations are not limited to these embodiments, and changes and the like made in design without departing from the gist of the present invention are included in the present invention. For example, although a description is given of the case where the frequency-voltage data conversion circuit 56 converts the frequency control data FCD into the frequency control voltage data FCV by using the conversion formula in the above-described embodiments, a conversion table may be used instead to convert the frequency control data FCD into the frequency control voltage data FCV. Moreover, the movement path is not limited to a straight road but is extensively applicable also to a winding road or a gradient road. Furthermore, the mobile environment information may also include azimuth information instead of, or in addition to, the location information.

[Industrial Applicability]

The mobile radio communications systems and mobile communication devices according to the present invention can be applied not only to mobile telephone devices but widely to mobile communication terminals, as well as to automobile telephones, automobile radios, fixed telephones installed on trains, and the like.

[Reference Signs List]

| | |
|---|---|
| 10 | Reference clock generation circuit |
| 11 | PLL circuit |
| 12 | Radio receiver section |
| 13 | Radio transmitter section |
| 14 | Finger circuit |
| 15 | RAKE circuit |
| 16 | Frequency offset estimation circuit |
| 17 | Accumulator circuit |
| 18 | Channel codec |
| 10 | Reference clock generation circuit |
| 11 | PLL circuit |
| 29, 44 | PLL circuit |
| 34 | Reference clock generation circuit |
| 36 | Finger circuit |
| 38 | Frequency offset estimation circuit |
| 39 | RAKE circuit |
| 40 | Accumulator circuit |
| 51 | Antenna |
| 52 | Transceiver section |
| 53 | Information processing section |
| 54 | Mobile station (mobile communication device) |
| 55 | Base station |
| 56 | Frequency-voltage data conversion circuit |
| 57 | Adder |
| 58 | Movement path |
| 59a, 59b | Radio wave reflector |
| 61 | PLL control circuit |
| 62 | PLL circuit |
| 63 | Mobile station (mobile communication device) |
| 64 | Mobile unit |
| 65 | Mobile environment information providing section |
| 66 | Base station |
| 67 | Antenna |
| 68 | Transceiver section |
| 69 | Information processing section |

**Claims**

1. A mobile radio communication system including a mobile station and a stationary base station, **characterized in that** the base station transmits a high-frequency signal to the mobile station, and
the mobile station predicts a frequency change in a reception high-frequency signal received from the base station based on mobile environment information on the mobile station provided from outside and controls a frequency of a local oscillator signal based on a prediction result.

2. The mobile radio communication system according to claim 1, **characterized in that** the mobile environment information includes location information on the mobile station and on the base station and velocity information on the mobile station along a movement path thereof, the location information and velocity information being required to calculate relative velocity of the mobile station along a direction in which radio waves from the base station arrive.

3. The mobile radio communication system according to claim 2, **characterized in that** the mobile environment information further includes location information on a radio wave reflector that changes the direction in which radio waves from the base station arrive.

4. The mobile radio communication system according to any one of claims 1 to 3, **characterized in that** at timing of passing the base station, the mobile station predicts the frequency change from a reception high-frequency signal frequency immediately before the passing to a reception high-frequency signal frequency immediately after the passing and performs following-control of the frequency of the local oscillator signal.

5. The mobile radio communication system according to any one of claims 1 to 4, **characterized in that** the base station provides the mobile environment information to the mobile station.

6. The mobile radio communication system according to any one of claims 1 to 4, **characterized in that** the mobile radio communication system further includes a mobile unit with the mobile station mounted thereon, and the mobile unit provides the mobile environment information to the mobile station.

7. A mobile communication device in a mobile radio communication system including at least one stationary base station, **characterized by** comprising:

    a transmission and reception means for performing radio communication with the base station; and
    a control means that predicts a frequency change in a reception high-frequency signal received from the base station based on mobile environment information provided from outside and controls a frequency of a local oscillator signal of the transmission and reception means based on a prediction result.

8. The mobile communication device according to claim 7, **characterized in that** the mobile environment information includes location information on the mobile communication device and on the base station and velocity information on the mobile communication device along a movement path thereof, the location information and velocity information being required to calculate relative velocity of the mobile communication device along a direction in which radio waves from the base station arrive.

9. The mobile communication device according to claim 8, **characterized in that** the mobile environment information further includes location information on a radio wave reflector that changes the direction in which radio waves from the base station arrive.

10. The mobile communication device according to any one of claims 7 to 9, **characterized in that** at timing of passing the base station, the control means predicts the frequency change from a reception high-frequency signal frequency immediately before the passing to a reception high-frequency signal frequency immediately after the passing and performs following-control of the frequency of the local oscillator signal.

11. The mobile communication device according to any one of claims 7 to 10, **characterized in that** the mobile environment information is received from the base station.

12. The mobile communication device according to any one of claims 7 to 10, **characterized in that** the mobile radio communication system further includes a mobile unit capable of communicating with the mobile communication device, and the mobile environment information is acquired from the mobile unit when the mobile communication device is mounted on the mobile unit.

13. A frequency control method for a mobile communication device performing radio communication with a stationary base station, **characterized by** comprising:

    by a transmission and reception means, receiving a reception high-frequency signal from the base station; and
    by a control means, predicting a frequency change in the reception high-frequency signal received from the base station based on mobile environment information provided from outside and controlling a frequency of a local oscillator signal of the transmission and reception means based on a prediction result.

14. The frequency control method according to claim 13, **characterized in that** the mobile environment information includes location information on the mobile communication device and on the base station and velocity information on the mobile communication device along a movement path thereof, the location information and velocity information being required to calculate relative velocity of the mobile communication device along a direction in which radio waves from the base station arrive.

15. The frequency control method according to claim 14, **characterized in that** the mobile environment information further includes location information on a radio wave reflector that changes the direction in which radio waves from the base station arrive.

16. The frequency control method according to any one of claims 13 to 15, **characterized in that** at timing of passing the base station, the control means predicts the frequency change from a reception high-frequency signal frequency immediately before the passing to a reception high-frequency signal frequency immediately after the passing and performs following-control of the frequency of the local oscillator signal.

17. The frequency control method according to any one of claims 13 to 16, **characterized in that** the mobile environment information is acquired from the base station.

18. The frequency control method according to any one of claims 13 to 16, **characterized in that** the mobile communication device is mounted on a mobile unit, and the mobile environment information is acquired from the mobile unit.

19. A program causing a control processor of a mobile communication device in a mobile radio communication system including at least one stationary base station to execute frequency control processing, **characterized by** causing the control processor to execute the processing of:

allowing a transmission and reception means to receive a reception high-frequency signal from the base station; predicting a frequency change in the reception high-frequency signal received from the base station based up mobile environment information provided from outside; and controlling a frequency of a local oscillator signal of the transmission and reception means based upon a prediction result.

20. The program according to claim 19, **characterized by** causing the control processor to execute the processing of, at timing of passing the base station, predicting the frequency change from a reception high-frequency signal frequency immediately before the passing to a reception high-frequency signal frequency immediately after the passing and performs following-control of the frequency of the local oscillator signal.

FIG.1

(RELATED ART)

# FIG.2

54; MOBILE STATION (MOBILE COMMUNICATION DEVICE)

MOBILE ENVIRONMENT
INFORMATION

$(x, d, u)$

51

52

53

RECEPTION DATA RDA

TRANSCEIVER
SECTION
(TRX)

TRANSMISSION DATA TDA

FREQUENCY CONTROL
DATA FCD

INFORMATION
PROCESSING
SECTION

BASE
STATION

55

EP 2 346 176 A1

# FIG.3

54; MOBILE STATION

MOBILE STATION'S VELOCITY

58; MOVEMENT PATH

u

F

BASE STATION-
MOBILE STATION
RELATIVE VELOCITY

v

d

x

55
BASE STATION

$$\frac{v}{u} = \frac{x}{\sqrt{x^2 + d^2}}$$

$$v = \frac{x}{\sqrt{x^2 + d^2}} \bullet u$$

# FIG.4

EP 2 346 176 A1

## FIG.5

EP 2 346 176 A1

52; TRANSCEIVER SECTION

# FIG.6

53 INFORMATION PROCESSING SECTION

FIG.7

EP 2 346 176 A1

FIG.8

54;MOBILE STATION (MOBILE COMMUNICATION DEVICE)

MOBILE ENVIRONMENT
INFORMATION

(x, d, w, u)

51

52

53

RDA

TRANSCEIVER
SECTION
(TRX)

TDA

FCD

INFORMATION
PROCESSING
SECTION

BASE
STATION

55

EP 2 346 176 A1

# FIG.9

59a; RADIO WAVE REFLECTOR (REFLECTING FACE)

58; MOVEMENT PATH

55; BASE STATION

54; MOBILE STATION

$$\frac{v}{u} = \frac{x}{\sqrt{x^2 + (2w+d)^2}}$$

$$v = \frac{x}{\sqrt{x^2 + (2w+d)^2}} \cdot u$$

EP 2 346 176 A1

# FIG.10

59b; RADIO WAVE REFLECTOR (REFLECTING FACE)

w

55; BASE STATION

MOBILE
54 STATION

v

58 MOVEMENT
PATH

d

F

u

x

$$\frac{v}{u} = \frac{x}{\sqrt{x^2 + (2w - d)^2}}$$

$$v = \frac{x}{\sqrt{x^2 + (2w - d)^2}} \cdot u$$

## FIG.11

60 ; TRANSCEIVER SECTION

EP 2 346 176 A1

28

# FIG.12

64; MOBILE UNIT

63; MOBILE STATION (MOBILE COMMUNICATION DEVICE)

| 68 | 69 | 65 |
|---|---|---|

66

67

BASE STATION

TRANSCEIVER SECTION (TRX)

RDA

TDA

FCD

INFORMATION PROCESSING SECTION

MOBILE ENVIRONMENT INFORMATION

$(x, d, u)$ OR $(x, d, w, u)$

MOBILE ENVIRONMENT INFORMATION PROVIDING SECTION

# FIG.13

69: INFORMATION PROCESSING SECTION

RDA → INPUT CIRCUIT (69a)

TDA ← / FCD ← OUTPUT CIRCUIT (69b)

MEMORY SECTION (69c)

CONTROL SECTION (CPU) (69g)

COMPUTATION SECTION (69d)  TIMER CIRCUIT (69e)

INTERFACE CIRCUIT (69f)

MOBILE ENVIRONMENT INFORMATION

(x, d, u) OR (x, d, w, u)

EP 2 346 176 A1

<table>
<tr><td align="center">**INTERNATIONAL SEARCH REPORT**</td><td>International application No.<br>PCT/JP2009/006028</td></tr>
</table>

A. CLASSIFICATION OF SUBJECT MATTER
*H04B1/26*(2006.01)i, *H04B1/16*(2006.01)i, *H04B1/707*(2006.01)i

According to International Patent Classification (IPC) or to both national classification and IPC

B. FIELDS SEARCHED

Minimum documentation searched (classification system followed by classification symbols)
H04B1/26, H04B1/16, H04B1/707

Documentation searched other than minimum documentation to the extent that such documents are included in the fields searched
| | | | |
|---|---|---|---|
| Jitsuyo Shinan Koho | 1922–1996 | Jitsuyo Shinan Toroku Koho | 1996–2010 |
| Kokai Jitsuyo Shinan Koho | 1971–2010 | Toroku Jitsuyo Shinan Koho | 1994–2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2008-219541 A (NEC Corp.),<br>18 September 2008 (18.09.2008),<br>paragraphs [0031] to [0034], [0046], [0054];<br>fig. 1, 2, 4<br>(Family: none) | 1,4-7,10-13,<br>16-20<br>2,8,14<br>3,9,15 |
| Y | JP 9-289480 A (Mitsubishi Electric Corp.),<br>04 November 1997 (04.11.1997),<br>paragraph [0003]<br>(Family: none) | 2,8,14 |
| A | JP 2000-214243 A (Mitsubishi Electric Corp.),<br>04 August 2000 (04.08.2000),<br>paragraph [0008]<br>(Family: none) | 1-20 |

☐ Further documents are listed in the continuation of Box C. ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>18 January, 2010 (18.01.10) | Date of mailing of the international search report<br>26 January, 2010 (26.01.10) |
|---|---|
| Name and mailing address of the ISA/<br>Japanese Patent Office | Authorized officer |
| Facsimile No. | Telephone No. |

Form PCT/ISA/210 (second sheet) (April 2007)

31

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001157263 A
- JP 2001119333 A